(19) Europäisches Patentamt

European Patent Office

Office européen des brevets

(11) **EP 1 531 002 A2**

(12) **EUROPEAN PATENT APPLICATION**

(43) Date of publication:
**18.05.2005 Bulletin 2005/20**

(51) Int Cl.⁷: **B01L 3/00**, F15C 5/00,
F04B 19/00, B81B 1/00,
F16K 31/02

(21) Application number: **04019427.6**

(22) Date of filing: **16.08.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: **06.11.2003 US 701502**

(71) Applicant: **Agilent Technologies, Inc.
Palo Alto, CA 94306 (US)**

(72) Inventor: **Sobek, Daniel
Portola Valley CA 94028 (US)**

(74) Representative: **Liesegang, Eva et al
Forrester & Boehmert,
Pettenkoferstrasse 20-22
80336 München (DE)**

(54) **Device and method to electrostatically seal microfluidic devices**

(57)     A microfluidic structure (200, 300, 400, 500, or 600) having an electrostatic sealing device is disclosed. The electrostatic sealing device includes a first electrode (102) and a second electrode (104) opposite the first electrode. At least one of the electrodes has an elastic layer (106) facing the other electrode. The second electrode is capable of moving toward the first electrode and forming a seal with the first electrode in response to a voltage difference between the two electrodes. The electrostatic sealing device eliminates the need for mechanical components that are traditionally used for gen-erating a mechanical force between two components of a microfluidic structure and thus reduces complexity of the microfluidic structure and possible interference with optical interrogation of the microfluidic structure. Moreover, the seal can be established or removed simply by turning the voltage on or off. The electrostatic sealing device can also be used as a valve, a pump, or a com-bination thereof, to control fluid flow in the microchan-nels of a microfluidic structure.

*FIG. 2A*

## Description

### Technical Field

The technical field is microfluidic devices and, in particular, electrostatic sealing devices adapted to microfluidic structures.

### Background

Microfluidic structures are commonly used in analytical devices. With the rapid development of affinity surface array techniques in recently years, there is a growing need to combine the use of microfluidic structure with affinity arrays. Intricate microfluidic systems can now be inexpensively mass-produced using tools developed by the semiconductor industry to miniaturize electronics.

Microfluidic devices are usually constructed in a multi-layer laminated structure where each layer has channels and structures fabricated from a laminate material to form microscale voids or channels where fluids flow. A microscale channel is generally defined as a fluid passage that has at least one internal cross-sectional dimension that is less than 500 μm and is typically between about 0.1 μm and about 500 μm.

The surface structure on each layer is usually manufactured through a patterning process. The classical patterning techniques used in microtechnology are photo- and electron beam lithography. Patterned layers are then bonded or sealed to each other to form the microfluidic structure. For example, U.S. Patent No. 5,443,890 describes a sealing device in a microfluidic channel assembly having first and second flat surface members which, when pressed against each other, define at least part of a microfluidic channel system between them.

Alternatively, a microfluidic structure may be produced using traditional plastic/ceramic replication techniques such as injection molding, casting, and hot embossing. In addition, removable microfluidic components can be employed to deliver samples or reagents to specific areas of a substrate. U.S. Patent Nos. 6,089, 853 and 6,326,058 describe patterning devices that have patterning cavities located on their surfaces. The devices can be attached to the surface of a substrate, and the substrate can be patterned by filling the patterning cavities with a patterning fluid.

U.S. Patent Application Publication Nos. 20030032046 and 20030047451 describe peelable and resealable patterning devices for biochemical assays. These peelable and resealable patterning devices make use of self-sealing members, which can be applied to the surface of a substrate and then removed to yield a flat surface that facilitates the performance of detection processes.

In all of the above-described cases, the patterning device must be pressed against the substrate by an externally-applied mechanical force to generate a seal between the patterning device and the substrate. Therefore, additional components, such as fasteners, are required to create the mechanical force necessary to generate the seal between the patterning device and the substrate. In the case of peelable and resealable patterning devices, the patterning devices need to be removed with mechanical force and then reassembled during the resealing process. This process of removal and resealing often damages the patterning devices or the patterned surfaces on the substrate.

Thus, a need exists for a patterning device that can be assembled and dissembled easily and quickly.

### Summary

A microfluidic structure having an electrostatic sealing device is disclosed. The electrostatic sealing device includes a first electrode and a second electrode opposite the first electrode. At least one of the electrodes contains an elastic layer facing the other electrode. The second electrode is capable of moving toward the first electrode and forming a seal with the first electrode in response to a voltage difference between the two electrodes.

Also disclosed is a microfluidic structure having an electrostatic sealing device in a microchannel. The electrostatic sealing device includes one or more pairs of electrodes disposed along the length of the microchannel. Each pair of electrodes contains a first electrode and a second electrode opposite to the first electrode. In each pair of electrodes, at least one of the electrodes is covered by an elastic layer, and the second electrode is capable of moving toward the first electrode and forming a seal with the first electrode in response to a voltage difference between the two electrodes.

Also disclosed is a method for forming a seal between two components of a microfluidic structure. A first component having a first electrode and a second component comprising a second electrode are provided. At least one of the electrodes has an external elastic layer. The first component is disposed opposite the second component with the electrodes opposed. A voltage difference is applied between the electrodes to form a seal between the electrodes.

The electrostatic sealing device eliminates the need for mechanical components that are traditionally used to apply a mechanical force between two components of a microfluidic structure and thus reduces complexity of the microfluidic structure and possible interference with optical interrogation of the microfluidic structure. Moreover, the seal can be established or removed easily and quickly by turning on or off a voltage.

**Brief Description of the Drawings**

The detailed description will refer to the following drawings, in which like numerals refer to like elements, and in which:

Figures 1A and 1B are cross-sectional views depicting an embodiment of an electrostatic sealing device in a pre-seal condition and sealed condition, respectively.

Figures 2A, 2B, 2C and 2D are cross-sectional views depicting microfluidic structures using the electrostatic sealing device to attach two components.

Figures 3A is a planar view depicting a microfluidic structure using the electrostatic sealing device as a control mechanism for microchannels.

Figure 3B and 3D are cross-sectional views depicting embodiments of the electrostatic sealing device used as a valve in a microchannel.

Figure 3C illustrates the operation of the embodiment shown in Figure 3B.

Figure 3E is a cross-sectional view depicting an embodiment of the electrostatic sealing device used as a pump in a microfluidic structure.

Figures 3F and 3G are cross-sectional views depicting the outward deformation of the membrane electrode of the electrostatic sealing device under hydraulic pressure and an embodiment to prevent membrane deformation.

**Detailed Description**

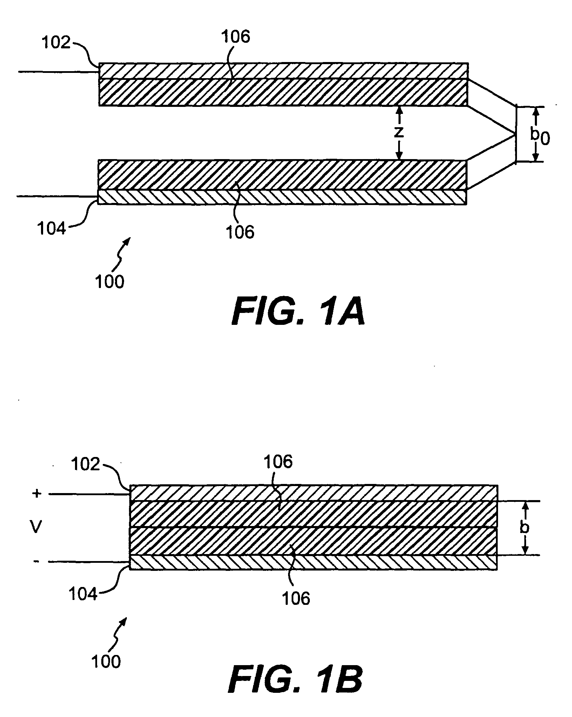

An embodiment of an electrostatic sealing device 100 in a pre-seal condition is shown in Figure 1A. The electrostatic sealing device 100 includes an electrode 102 and an electrode 104. The external surface of each electrode is covered by an elastic layer 106. In the pre-seal condition, the electrostatic sealing device 100 can be modeled as a parallel plate capacitor with a dielectric composed of two elastic layers with a dielectric constant $\varepsilon$ and a combined thickness of $b_0$, and a gap of height $z$. Depending on the application, the gap is filled with air or fluid.

A voltage applied between the electrode 102 and the electrode 104 establishes an electric field between the electrodes. The electric field generates an electrostatic force $f$ internal to the electrostatic sealing device 100 that pulls the electrodes 102 and 104 towards and into contact with each other.

As shown in Figure 1A, the region between the parallel electrodes 102 and 104 is filled by two elastic layers 106 having a dielectric constant $\varepsilon$ and a combined thickness $b_0$, and a gap having a dielectric constant $\varepsilon_0$ and a thickness $z$. The total distance between the electrodes 102 and 104, $b_0 + z$, is small compared to the linear dimensions of the electrode plates, so fringing fields can be ignored. Thus, electric fields in the elastic layers 106 and in the gap are uniform. When a voltage V is applied between the electrodes 102 and 104, the electrostatic force $f$ acting on the electrode 102 may be expressed as follows.

$$f = V^2 dC \, / 2 dz, \tag{1}$$

with

$$C = \varepsilon_0 A \, / \, (z + b_0 \, \varepsilon_0 / \varepsilon) \tag{2}$$

where C is the capacitance between the electrodes 102 and 104, and A is the surface area of the electrodes 102 and 104 (if electrodes 102 and 104 have different sizes, A is the surface area of the smaller electrode).

Incorporating equation (2) into equation (1) and differentiating C with respect to $z$ lead to the expression

$$f = -V^2 \, \varepsilon_0 A \, / \, 2(z + b_0 \, \varepsilon_0 / \varepsilon)^2 \tag{3}$$

The negative value of $f$ reflects the fact that charges of one polarity on the electrode 102 are attracted toward charges of opposite polarity on the electrode 104.

Figure 1B shows the electrostatic sealing device 100 in the sealed condition resulting from the application of the voltage between the electrodes 102 and 104. In the sealed condition, the thickness $z$ of the gap is zero, dielectric

constant $\varepsilon_0$ equals $\varepsilon$, and the distance between the electrodes 102 and 104 is $b$. Since the elastic layers 106 will be compressed when the seal is made, $b$ is smaller than $b_o$, which denotes the combined thickness of the elastic layers 106 in their uncompressed state. The electrostatic pressure $p$ between the electrode 102 and 104 can be expressed as:

$$p = f/A = -\varepsilon V^2/2b^2 \tag{4}$$

According to equation (4), the electrostatic pressure $p$ is proportional to the square of the voltage applied between the electrodes 102 and 104, and is inversely proportional to the square of the thickness $b$ of the elastic layers 106. Table 1 lists the electrostatic pressures $p$ generated for different thicknesses of the elastic layers, assuming that the dielectric constant $\varepsilon$ of the material of the elastic layers 106 is twice that of air ($\varepsilon_0 = 8.854 \times 10^{-12}$ F/m) for field strengths in the 100-400 mV/$\mu$m range.

Table 1:

| Electrostatic pressure at field strengths in the 100-400 mV/$\mu$m range. | | | |
|---|---|---|---|
| Elastic layer thickness [$\mu$m] | Dielectric Constant $\varepsilon$ | Applied Voltage [mV] | Electrostatic Pressure $p$ [Atmosphere] |
| 1 | $2\,\varepsilon_0$ | 100 | 0.87 |
| | | 400 | 14 |
| 10 | $2\,\varepsilon_0$ | 1,000 | 0.87 |
| | | 4,000 | 14 |
| 25 | $2\,\varepsilon_0$ | 2,500 | 0.87 |
| | | 10,000 | 14 |

In the embodiment shown in Figures 1A and 1B, each of the electrodes 102 and 104 is covered by a respective elastic layer 106. However, an embodiment of the electrostatic sealing device 100 in which only one of the electrodes is covered by an elastic layer 106 will function properly, as long as the uncovered electrode is capable of forming a tight seal with the elastic layer covering the other electrode and, in an embodiment in which the electrode 102 is exposed to fluid during operation, the electrode 102 is coated with an insulating material to prevent the fluid from providing a conductive path between the electrode 102 and ground.

Since the electrostatic pressure $p$ generated under the conditions listed in Table 1 is sufficient to create a tight seal between two elastic layers 106 (when both electrodes are covered with elastic layers), between a single elastic layer and the surface of an electrode (when only one electrode is covered with an elastic layer), or between a single elastic layer and a substrate of a material such as glass, plastic or metal (when one electrode is embedded in the substrate), the electrostatic sealing device 100 can form a seal without the application of an external mechanical force. The electrostatic sealing device 100 is ideal for applications that require multiple positioning of microfluidic structures against a substrate, because the seal can be established simply by applying a voltage between the electrode 102 and the electrode 104, and can be removed by removing the voltage from, or by grounding, the electrode 102. Moreover, precise alignment between the electrodes is not necessary in the pre-seal condition. The electrodes tend to align with each other automatically due to the electrostatic attraction between them when a voltage is applied.

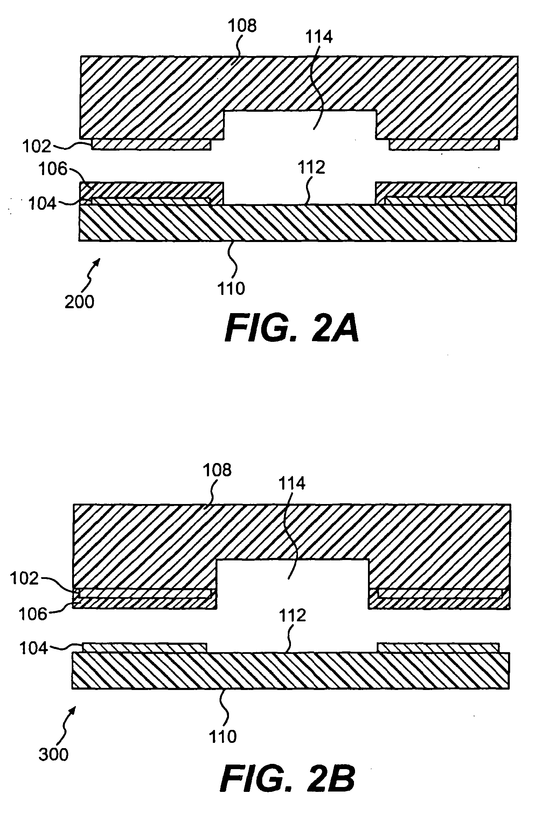

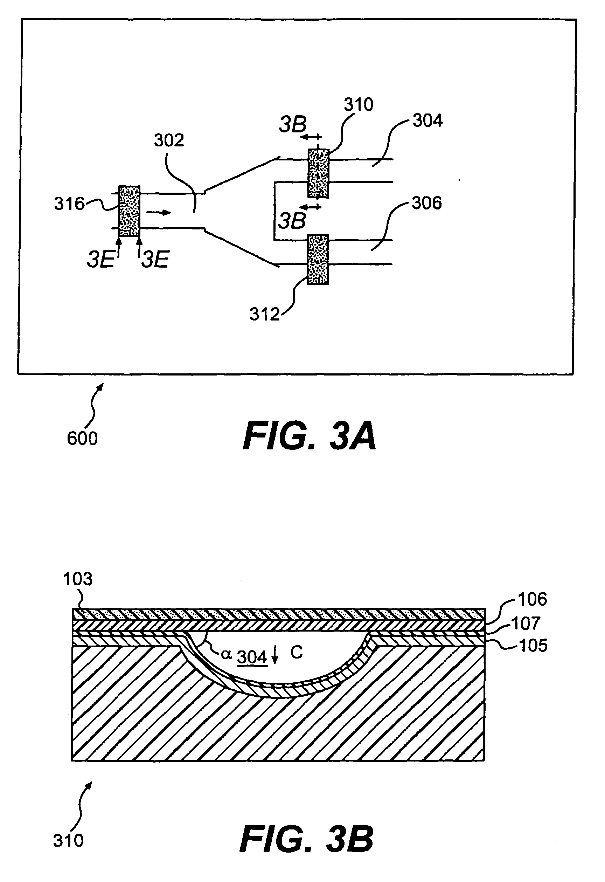

Figures 2A-2D and 3A-3G illustrate several possible embodiments of microfluidic structures in accordance with the invention incorporating embodiments of the electrostatic sealing device just described. Figure 2A shows a cross-sectional view of an embodiment of a microfluidic structure 200 that has two components capable of forming a seal between them. In this embodiment, a removable structure 108 is temporarily sealed on top of a substrate 110. The substrate 110 includes an affinity surface 112 that supports, for example, a DNA or protein array. The removable structure 108 defines a microfluidic channel 114. The electrode 102 is located on a surface of the removable structure 108 and the electrode 104 is located on a surface of the substrate 110.

In this embodiment, only the electrode 104 is covered with the elastic layer 106. The elastic layer 106 will insulate the major surface of the electrode 102 from liquid located in the microfluidic channel 114 that exists after the formation of a seal between the electrode 102 and the electrode 104. To prevent the fluid in microchannel 114 from providing a conductive path from the sides of the electrode 104 to ground, the electrode 102 may be covered with a thin layer of insulating material or with an elastic layer 106 (not shown in Figure 2A).

The removable structure 108 is attached to the substrate 110 by aligning the electrode 102 with the electrode 104 and applying a voltage between the electrode 102 and the electrode 104. The electrostatic force between the electrodes will pull the electrode 102 toward the elastic layer covering the surface of the electrode 104. Contact between the electrode 102 and the elastic layer 106 on the electrode 104 forms a seal between the removable structure 108 and the substrate 110.

The attachment of the removable structure 108 and the substrate 110 to form the microfluidic structure 200 closes the open section of the microfluidic channel 114 and allows the delivery of reagents, buffers, analytes, etc., as well as the performance of other procedures on the affinity surface 112 of the substrate 110.

Figure 2B shows.another embodiment of a microfluidic structure 300 in which the electrode 102 is located on a surface of the removable structure 108 and the exposed surfaces of the electrode 102 are coated with the elastic layer 106. The electrode 104 is located on a surface of the substrate 110 and is not covered with any elastic layer. In this embodiment, the elastic layer 106 fully insulates the electrode 102 from fluid located in the microfluidic channel 114.

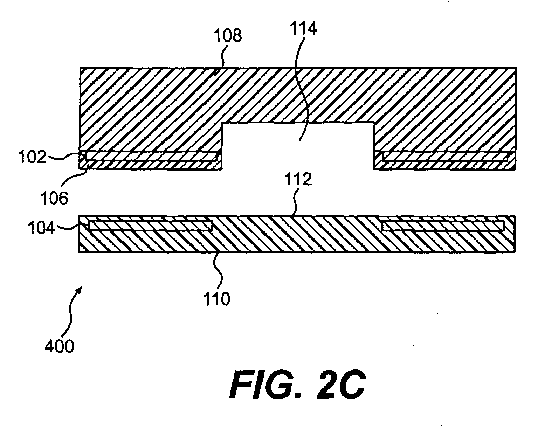

Figure 2C shows another embodiment of a microfluidic structure 400 in which the electrode 104 is embedded in the substrate 110. The electrode 104 can be embedded by the manufacturing process of the substrate 110. Alternatively, the electrode 104 can be deposited on a surface of the substrate 110, and the surface then covered by a thin film of the same material as the substrate 110 or of another material. This substrate structure provides a flat surface that facilitates the performance of detection processes.

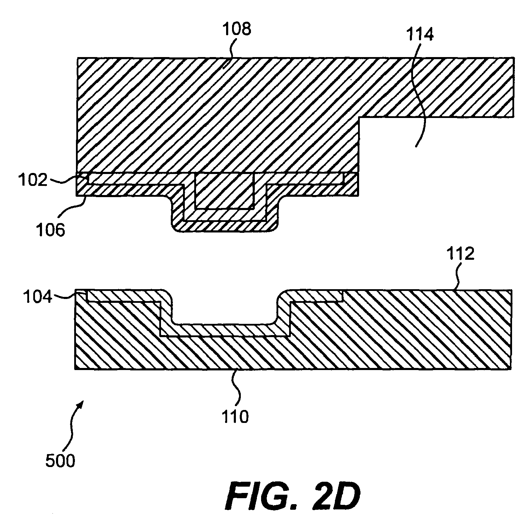

Figure 2D shows another embodiment of a microfluidic structure 500 in which the opposed surfaces of the removable structure 108 and the substrate 110 are patterned with matching and interlocking features and the electrodes 102 and 104 are conformally deposited on the removable structure 108 and the substrate 110, respectively. At least one of the electrodes 102 and 104 is covered with elastic layer 106. The interlocking feature increases both the strength and hermeticity of the seal and facilitates the alignment between the removable structure 108 and the substrate 110. The contouring of the electrodes concentrates the electric field at the corners of the interlocking structure. Rounding the corners of the interlocking structure reduces the maximum field gradient and prevents electrostatic breakdown at the corners.

In the above-described embodiments, the substrate 110 and removable patterning structure 108 may be fabricated using any organic material, inorganic materials or combination thereof that meets the thermal, mechanical, chemical and electrical insulation requirements of a particular application. Examples of the organic materials include, but are not limited to, polystyrene, polypropylene, polyimide, cyclic olefin copolymer (COC), and polyetheretherketone (PEEK). Examples of the inorganic materials include, but are not limited to, glass, ceramics, oxides, crystalline materials, and metals.

The electrodes 102 and 104 are typically composed of one or more thin layers of a conducting material. The thickness of the electrodes is typically in the range of 20 nm - 500 $\mu$m, and more typically in the range of 100nm - 5 $\mu$m. In one embodiment, the electrodes 102 and 104 are composed of one or more layers each of metal such as gold, silver, platinum, palladium, copper, aluminum or an alloy comprising one or more of such metals. In another embodiment, the electrodes 102 and 104 comprise a layer of indium tin oxide (ITO). The electrodes 102 and 104 can also comprise one or more layers of respective elastic conducting materials or elastic conducting-polymer materials, such as polyaniline and polypyrrole. In an embodiment, one or both of the removable structure 108 and the substrate 110 is made of a conducting material, such as a conducting polymer, doped silicon, or metal. In this embodiment, the entire removable structure 108 or the substrate 110 serves as the electrode 102 or 104, respectively.

The geometry of the electrodes 102 and 104 is typically optimized to provide an adequate sealing force for a given distribution of the internal channel pressure. The electrode geometry may also be optimized to provide an automatic alignment between the substrate 110 and the removable structure 108 in directions parallel to the plane of the major surface of the substrate 110.

The material of the elastic layer 106 can be any suitable elastic insulating material. The material of the elastic layer 106 could advantageously have a high arcing resistance and a high dielectric constant, be chemically compatible with the application, and be hydrophobic, although these properties may not be advantageous in all applications. Examples of the material of the elastic layer 106 include, but are not limited to, rubber, thermoplastic rubber, silicone rubber, fluoroelastomer, acrylic, COC, urethanes, polymethylmethacrylate (PMMA), polycarbonate, polytetrafluoroethylene, polyvinylchloride (PVC), polydimethylsiloxane (PDMS), polysulfone, siloxanes, or polyamides. The selection of the material will vary according to the microfluidic device and the assay. The material of the elastic layer 106 may be spin-coated or stamped on the substrate surface, on top of the electrodes, or on both.

In embodiments of the microfluidic device, the components thereof may be transparent, reflecting, or opaque depending on the optical requirements of the application.

Figure 3A illustrates another embodiment of a microfluidic structure in accordance with the invention incorporating an embodiment of an electrostatic sealing device. In this embodiment, electrostatic sealing devices 310, 312, and 316 are used to regulate fluid flow in and between the microchannels 302, 304 and 306 of a microfluidic structure 600. The electrostatic sealing devices 310 and 312 located at the input end of microchannels 304 and 306, respectively, allows either of the microchannels 304 and 306 to be selectively opened or closed, thus permitting a controlled movement of fluid within different parts of the microfluidic structure 600.

Figure 3B is a cross-sectional view of an embodiment of the electrostatic sealing device 310 along the line 3B-3B. The electrostatic sealing device 312 is similar in structure and will not be separately described. In this embodiment, the electrostatic sealing device 310 is located on a U- or V-shaped microchannel 304 that is coated over a portion of its length with a channel electrode 105. The channel electrode is coated with an elastic layer 107. A lengthwise portion of the microchannel 304 is covered with an elastic membrane electrode 103. The surface of the membrane electrode 103 facing the channel electrode 105 is coated by the elastic layer 106.

A voltage applied between the elastic membrane electrode 103 and the channel electrode 105 establishes an electric field that pulls the elastic membrane electrode 103 towards the channel electrode 105 in the direction shown by arrow C. Because the microchannel 304 has a U- or V-shaped cross-section area, the distance between the membrane electrode 103 and the channel electrode 105 is a maximum at the center of the microchannel 304 and becomes smaller towards the edges of the microchannel 304. Accordingly, the electrostatic pressure $p$ is greatest at the edges of the microchannel 304, since the electrostatic pressure $p$ is inversely proportional to the distance between the electrodes 103 and 105 (see equation (2) above).

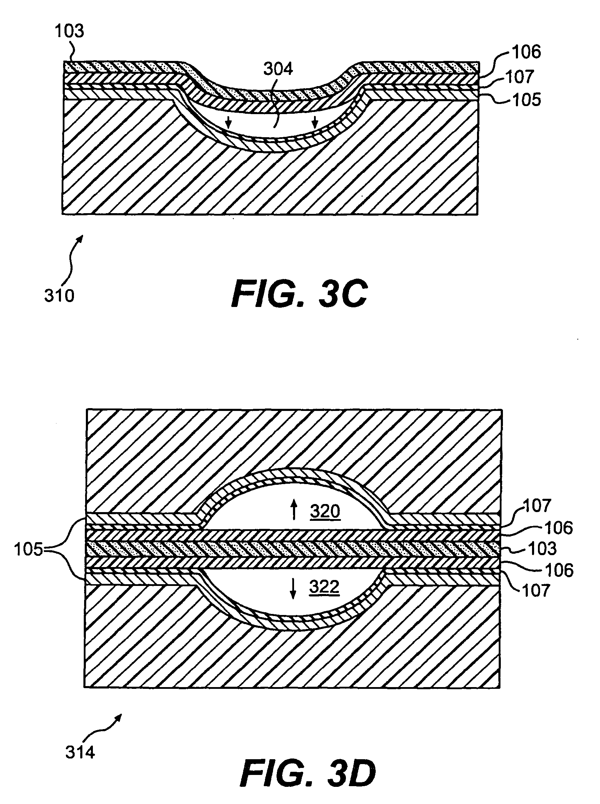

As shown in Figure 3C, portions of the elastic membrane electrode 103 adjacent the edges of the microchannel 304 are pulled toward the channel electrode 105 once the electrostatic pressure $p$ at the edge of the microchannel 304 reaches the required magnitude. The movement of the elastic membrane electrode 103 into the microchannel 304 reduces the distance between the elastic membrane electrode 103 and the channel electrode 105 and increases the strength of the electrostatic field between the electrodes 103 and 105. The increased electrostatic field strength in turn causes further movement of the elastic membrane electrode 103 into the microchannel. Thus, contact between the elastic membrane electrode 103 and the channel electrode 105 occurs initially at the edges of the microchannel 304 and moves progressively towards the center of the microchannel. The relative motion of the electrodes 103 and 105 as they come into contact is analogous to two zip fasteners moving in opposite directions from the edges of the microchannel 304 to meet at the center of the microchannel.

The above-described "zipper" effect as the elastic membrane electrode 103 and the channel electrode 105 come into contact is opposed by the elasticity of the elastic membrane electrode 103 and the elastic layer 106, as well as by the pressure exerted by the fluid in the microchannel 304. The applied voltage needed to initiate the "zipper" effect is reduced by reducing the gap between the elastic membrane electrode 103 and the channel electrode 105 at the edges of the microchannel 304. The gap can be reduced by structuring the U- or V-shaped microchannel 304 to form a small contact angle $\alpha$ (see Figure 3B) with the membrane electrode 103 at the edges of the microchannel 304. In an embodiment, the contact angle is less than 45°. In another embodiment, the contact angle is less than 30°.

The electrostatic sealing device 310 described above can be used as a shut-off valve, which has only an on state or an off state, or as a regulating valve, which additionally has partially on states. By establishing an appropriate voltage between the elastic membrane electrode 103 and the channel electrode 105, the electrodes 103 and 105 may partially or fully seal the microchannel 304 and thus regulate fluid flow in the microchannel 304. In the electrostatic sealing device 310, the one of the elastic membrane electrode 103 and the channel electrode 105 that is at the higher voltage when a voltage is applied between the electrodes is coated with an elastic layer or a layer of another insulating material to prevent the fluid in the microchannel 304 from providing a leakage path from the higher voltage electrode to ground.

Figure 3D is a cross-sectional view of another microfluidic device in accordance with the invention incorporating an embodiment of an electronic sealing device 314. The electrostatic sealing device 314 is located on two U- or V-shaped microchannels 320 and 322 that are aligned with their open sections facing each other. The open sections are covered by a common elastic membrane electrode 103 coated on both sides with an elastic layer 106. Each of the microchannels 320 and 322 is coated over a section of its length opposite the elastic membrane electrode with a respective channel electrode 105. Each channel electrode is coated with an elastic layer 107. In this embodiment, the elastic membrane electrode 103 is a common electrode and is moved into the microchannel 320 or into the microchannel 322, as shown by the arrows E and F, depending on which of the channel electrodes 105 has the voltage applied.

In an embodiment, the inlets of the microchannels 320 and 322 are connected to a common microchannel (not shown). In such embodiment, the channel electrode 105 to which the voltage is applied selectively causes the microfluidic device to route fluid flowing in the common microchannel through the microchannel 320 or through the microchannel 322. When voltage is applied to neither of the channel electrodes, the fluid flows through both of the microchannels.

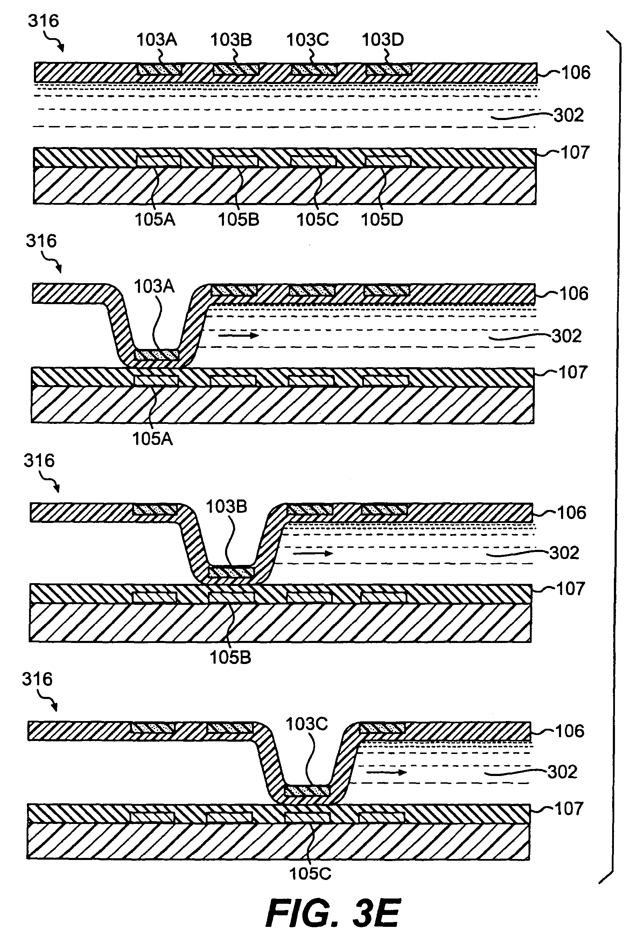

An electrostatic sealing device in accordance with the invention may also be structured as pump for a microfluidic structure. Figure 3E is a cross-sectional view of an embodiment of the electrostatic sealing device 316 shown in Figure 3A along the section line 3E-3E. In this embodiment, at least one of the elastic membrane electrode 103 and the channel electrode 105 is composed of electrode segments. In the example shown, both electrodes are composed of electrode segments. Thus, the electrostatic sealing device 316 has pairs of the electrode segments (pairs 103A and 105A, 103B and 105B, 103C and 105C and 103D and 105D) disposed in tandem along the length of the V- or U-shaped microchannel 302. As shown in Figure 3E, a voltage sequentially applied between the electrode segment pairs 103A and 105A through 103D and 105D causes the electrostatic sealing device 316 to operate as a pump. The sequential sealing of the microchannel 302 by the electrode segment pairs 103A and 105A through 103D and 105D pushes the liquid in the microchannel 302 in the direction shown by the arrow. The pumping efficiency, and, hence the pressure generated, can be controlled by the way in which the voltage is sequentially applied to the electrode segment pairs. For example, a longer interval between the times at which the voltage is applied to each electrode segment pair leads to a lower pumping efficiency. A shorter powering interval between the times at which the voltage is applied to each electrode segment pair results in a higher pumping efficiency because the electrostatic seal provided by the electrode segment pair from which the voltage is removed does not fully relax before the electrostatic seal provided by electrode segment pair to which the voltage is newly applied. Circuits that allow independent control of each electrode segment or electrode segment pair are well-known in the art. Such circuits allow an operator of the electrostatic sealing device 316 to apply the voltage to the electrode segments sequentially along the length of the microchannel 302. Algorithms that allow different powering intervals are also well-known in the art.

Pumping efficiency is maximized by additionally applying the voltage to the next electrode segment pair in the sequence before the voltage is removed from the previous electrode segment pair in the sequence. For example, the voltage is additionally applied to the electrode segment pair 103B and 105B before the voltage is removed from electrode segment pair 103A and 105A. The voltage is removed from electrode segment pair 103A and 105A after the time required for the voltage to fully establish the electrostatic seal between the electrode segment pair 103B and 105B. After the voltage has been applied to the electrode segment pair 103D and 105D, the applying sequence repeats with the application of the voltage to the electrode segment pair 103A and 105A. Alternatively, the voltage can be cumulatively applied to the electrode segment pairs in the sequence 103A and 105A through 103D and 105D.

In an alternative embodiment of the pump provided by the electrostatic sealing device 316, only one of the elastic membrane electrode and the channel electrode is composed of electrode segments disposed along the length of the microchannel 302. For example, a channel electrode common to all the electrode segments 103A-103D is a provided by a continuous electrode coating located on the inner surface of the microchannel channel 302. The elastic membrane electrode remains composed of electrode segments 103A-103D as shown in Figure 3E. In such embodiment, an electrode segment pair can be regarded as existing between each of the electrode segments 103A-103D and the portion of the common channel electrode opposite the electrode segment. Such embodiment of the electrostatic sealing device 316 works as a pump by sequentially applying a voltage between the common channel electrode and each of the electrode segments 103A-103D in a manner similar to that described above. Alternatively, the elastic membrane electrode may be structured as a common electrode and the channel electrode may be composed of electrode segments.

Embodiments of the pump provided by the electrostatic sealing device 316 may be used to control fluid movement within the microfluidic device.

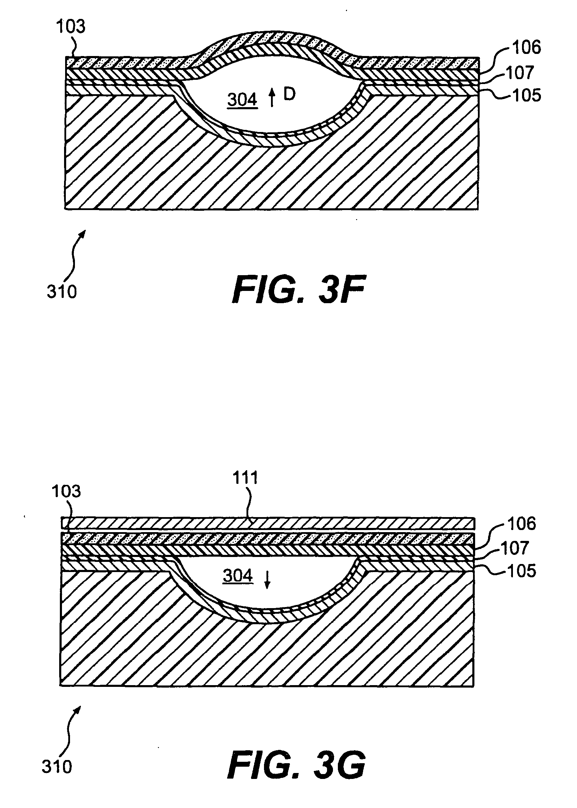

In embodiments of the electrostatic sealing device 310 described above with reference to Figure 3C, the elastic membrane electrode 103 may deform in response to the pressure of the fluid in the microchannel 304, as shown in Figure 3F. The pressure may push the elastic membrane electrode 103 in the outward direction as indicated by the arrow D. The resulting increased cross-sectional area changes the flow resistance of the microchannel 304. In some applications, this property of the electrostatic sealing device 310 may be desirable. In other applications, this property may be undesirable.

Figure 3G shows another embodiment of the electrostatic sealing device 310 in which the outward movement of the elastic membrane electrode 103 is constrained by a rigid layer 111 disposed over the elastic membrane electrode 103. The rigid layer 111, however, is not attached to the elastic membrane electrode 103 and therefore does not constrain the movement of the elastic membrane electrode 103 into the microchannel 304 when a voltage is applied between the elastic membrane electrode and the channel electrode 105.

Many other configurations of the microfluidic device and electrostatic sealing device in accordance with the invention are possible. Depending on the application, the electrostatic sealing device can be used as a valve, a pump, a flow regulator, or a combination thereof. The microfluidic structures 200, 300, 400, 500 and 600 disclosed herein can be used in a variety of applications. Examples include, but are not limited to, detection of binding events such as cell-membrane, cell-cell, cell-substrate/receptor, antibody-antigen, hormone-receptor, small molecule-protein, polynucleotide-polynucleotide, and protein-polynucleotide binding events; detection of chemical modifications such as isomerization, oxidation, and reduction; and detection of biochemical reactions such as enzymatic modification (e.g., cleavage by proteases, phosphotases, lipases, endonucleases, exonucleases, and/or transferases). Accordingly, the microfluidic structures disclosed herein may be used to perform a variety of assays that include, but are not limited to, determination of enzymatic inhibition by a collection of compounds in solution; determination of substrates for an enzyme (fishing/selectivity), identifying binding partners for immobilized biomolecules (such as peptides, proteins, nucleic acids, antibodies, enzymes, glycoproteins, proteoglycans, and other biological materials, as well as chemical substances), identifying inhibitors of protein-protein, protein-small molecule or protein-receptor binding, determination of the activity of a collection of enzymes (in one or more than one well), and generating selectivity indices for inhibitors of enzymes or other biologically active molecules.

Although preferred embodiments and their advantages have been described in detail, various changes, substitutions and alterations can be made herein without departing from the scope of the devices and methods as defined by the appended claims and their equivalents.

## Claims

1. A microfluidic structure (200, 300, 400, 500, and 600) comprising:

   an electrostatic sealing device comprising:

   a first electrode (102);
   a second electrode (104) opposite the first electrode, the second electrode capable of moving toward the first electrode and forming a seal with the first electrode in response to a voltage difference between the first electrode and the second electrode,

   wherein at least one of the first electrode and the second electrode comprises a elastic layer (106) facing the other electrode.

2. The microfluidic structure of claim 1, wherein at least one of the first electrode and the second electrode is a thin film electrode.

3. The microfluidic structure of claim 1, wherein at least one of the first electrode and the second electrode comprises an elastic conducting polymer.

4. The microfluidic structure of one of the preceding claims, wherein:

   the microfluidic structure additionally comprises:

   a first component comprising the first electrode, and
   a second component comprising the second electrode; and

   the seal is formed between the first electrode and the second electrode when the second component is aligned relative to the first component such that the second electrode proximate to the first electrode and the voltage is applied between the electrodes, the seal detachably interconnecting the first component and the second component.

5. The microfluidic structure of one of the preceding claims, wherein:

   the microfluidic structure additionally comprises:

   a substrate, and
   a microchannel (304) defined in the substrate;

   the first electrode comprises an elastic membrane covering a lengthwise portion of the microchannel; and
   the second electrode is located in the microchannel opposite the first electrode.

6. The microfluidic structure of claim 5, additionally comprising a layer of rigid material (111) over the elastic membrane.

7. The microfluidic structure of claim 5 or 6, wherein:

   at least one of the electrodes comprises electrode segments disposed along the length of the microchannel; and
   the microfluidic structure additionally comprises a circuit operable to apply voltage to the electrode segments independently.

**8.** A method for pumping fluid through a microchannel in a microfluidic structure (600), the method comprising:

provide the microfluidic structure of claim 7;
establishing voltage differences between the electrode segments and the other electrode in a sequence progressing along the length of the microchannel such that electrostatic seals sequentially formed between the electrode segments and the other electrode displace the fluid in a desired direction.

**9.** A method for electrostatically forming a seal in a microchannel in a microfluidic structure (600), the method comprising:

providing the microfluidic structure of claim 5; and
applying a voltage difference between the first electrode and the second electrode to form the seal between the electrodes and block the microchannel.

**10.** A method for detachably connecting two components of a microfluidic structure (200, 300, 400 or 500), the method comprising:

providing a first component comprising a first electrode (102);
providing a second component comprising a second electrode (104);
disposing the first component opposite the second component with the electrodes opposed; and
applying a voltage difference between the first electrode and the second electrode to form a seal between the electrodes.

**FIG. 1A**

**FIG. 1B**

EP 1 531 002 A2

108

114

102

106

112

104

110

**FIG. 2A**

200

108

114

102

106

112

104

110

**FIG. 2B**

300

11

**FIG. 2C**

**FIG. 2D**

**FIG. 3A**

**FIG. 3B**

**FIG. 3C**

**FIG. 3D**

**FIG. 3E**

103     106
107
105

304 ↑ D

310

# FIG. 3F

111

103     106
107
105

304 ↓

310

# FIG. 3G